# EUROPEAN PATENT APPLICATION

(11) **EP 4 791 148 A1**
(43) Date of publication of application: **12.08.2026**
(21) Application number: 25156423.3
(22) Date of filing: 07.02.2025
(51) Int. Cl.: H10D 84/01, H01L 23/482, H01L 25/065, H10D 30/00, H10D 64/23, H10D 84/83, H10D 84/85, H10D 88/00

(54) **A COMPLEMENTARY FIELD-EFFECT TRANSISTOR AND A METHOD OF MANUFACTURING THEREOF**

(71) Applicant: Huawei Technologies Co., Ltd., Shenzhen, Guangdong 518129 (CN)
(72) Inventor: YAKIMETS, Dmitry, 80992 Munich (DE)
(74) Representative: Goddar, Heinz J.

(57) **Abstract**

In some examples, a complementary field-effect transistor (CFET) comprises a first transistor formed on a first level, and a second transistor formed on a second level, wherein the second level is stacked on the first level, wherein a channel of the first transistor is offset from a channel of the second transistor while maintaining partial overlap between the channels.

## Description

### TECHNICAL FIELD

The present disclosure relates, in general, to semiconductor devices. Aspects of the disclosure relate to complementary field-effect transistor devices for advanced scaling of semiconductor technologies.

### BACKGROUND

The continuous scaling of semiconductor devices has been a driving force in the advancement of computing technologies, enabling smaller, faster, and more energy-efficient chips. As feature sizes approach the limits of traditional scaling methods, new device architectures are required to address increasing design and manufacturing challenges.

Among these advanced architectures, complementary field-effect transistors (CFETs) have emerged as a promising candidate for future semiconductor scaling. CFETs offer a vertically stacked transistor configuration, integrating n-type and p-type transistors stacked on top of each other. This configuration reduces the footprint of the device, improving packing density and enabling higher performance per unit area.

Two primary approaches to CFET integration are currently employed: monolithic integration and sequential integration. Monolithic integration involves fabricating both levels on a single wafer, while sequential integration fabricates the transistors on separate wafers and bonds them together using hybrid wafer bonding. Sequential integration provides greater flexibility in transistor design, allowing diverse device types to be stacked, but it introduces additional complexities related to alignment and interconnectivity.

One challenge common to both integration approaches is ensuring access to all transistor terminals. The stacked configuration inherently complicates routing to the source, drain, and gate terminals of both levels. Current solutions often rely on complex middle-of-line (MOL) interconnect routing layers near the device to resolve this issue. While functional, these approaches can introduce additional manufacturing complexity, increased resistance, and parasitic capacitance, which may degrade performance.

Another issue arises when the channels of the top and bottom transistors are perfectly aligned. This alignment can make it difficult to independently control the gates of the stacked transistors in monolithic designs, and it often necessitates intricate routing strategies in sequentially bonded devices. Conversely, some designs use perpendicularly oriented channels to address terminal accessibility, but this approach complicates standard cell design and can reduce area efficiency in many applications.

### SUMMARY

An objective of the present disclosure is to provide a complementary field-effect transistor (CFET) having improved accessibility to the terminals of the device.

The foregoing and other objectives are achieved by the features of the independent claims.

Further implementation forms are apparent from the dependent claims, the description and the Figures.

A first aspect of the present disclosure provides a complementary field-effect transistor (CFET) device comprising a first transistor formed on a first level, and a second transistor formed on a second level, wherein the second level is stacked on the first level, wherein a channel of the first transistor is offset from a channel of the second transistor while maintaining partial overlap between the channels.

Accordingly, the offset channels can allow the access to a bottom level device from the top and a top level device from the bottom, meaning that interconnects no longer require much of complex routing and can be realised using simple vias. Advantageously, the channels of the top and bottom devices are offset from each other while still maintaining a sufficient degree of overlap to ensure that the main CFET benefit of reduced device area remains in place.

The second level may be stacked on the first level along a first axis, wherein the channel of the first transistor and the channel of the second transistor are arranged along a second axis, wherein the second axis is perpendicular to the first axis, wherein a portion of the channel of the first transistor overlaps the channel of the second transistor along a third axis, wherein the third axis is perpendicular to the first axis and the second axis.

An amount of offset between the channel of the first transistor and the channel of the second transistor may be sufficient to accommodate a metal via to source/drain regions of the first transistor and an isolating dielectric between the via and source/drain region of the second transistor.

The first transistor may comprise an n-type metal-oxide-semiconductor (NMOS) transistor, and the second transistor may comprise a p-type metal-oxide-semiconductor (PMOS) transistor, or the first transistor may comprise the PMOS transistor, and the second transistor may comprise the NMOS transistor.

The channel of the first transistor and/or the channel of the second transistor may comprise at least one nanosheet.

The channel of the first transistor and/or the channel of the second transistor may comprise a channel surrounded by a gate electrode on three or four sides, forming a fork-sheet or gate-all-around (GAA) transistor, respectively.

A hybrid bonding interface may be arranged between the first transistor and the second transistor, wherein the hybrid bonding interface is arranged to electrically connect terminals of the first transistor to terminals of the second transistor.

A middle-of-line (MOL) routing layer may be connected via the hybrid bonding interface and may be arranged to provide signal and power connections to the first transistor and the second transistor.

A second aspect of the present disclosure provides a semiconductor device comprising a plurality of complementary field-effect transistor (CFET) devices, each CFET device comprising a first transistor formed in a first level, and a second transistor formed in a second level, wherein the second level is stacked on the first level, wherein a channel of the first transistor is offset from a channel of the second transistor while maintaining partial overlap between the channels.

A third aspect of the present disclosure provides a method of manufacturing a complementary field-effect transistor (CFET) device, the method comprising forming a first transistor on a first wafer, forming a second transistor on a second wafer, stacking the second wafer over the first wafer such that a channel of the first transistor is aligned with a channel of the second transistor along a channel direction, and laterally offsetting the channel of the second transistor relative to the channel of the first transistor such that the second channel partially overlaps the first channel.

The second level may be stacked on the first level along a first axis, wherein the channel of the first transistor and the channel of the second transistor are arranged along a second axis, wherein the second axis is perpendicular to the first axis, wherein a portion of the channel of the first transistor overlaps the channel of the second transistor along a third axis, wherein the third axis is perpendicular to the first axis and the second axis.

An amount of offset between the channel of the first transistor and the channel of the second transistor may be sufficient to accommodate a metal via to source/drain regions of the first transistor and an isolating dielectric between the via and the source/drain region of the second transistor.

Forming the first transistor may comprise forming an n-type metal-oxide-semiconductor (NMOS) transistor, and forming the second transistor may comprise forming a p-type metal-oxide-semiconductor (PMOS) transistor, or forming the first transistor may comprise forming the PMOS transistor, and forming the second transistor may comprise forming the NMOS transistor.

The method may further comprise creating a hybrid bonding interface between the first wafer and the second wafer to electrically connect terminals of the first transistor and the second transistor.

The method may further comprise forming a middle-of-line (MOL) routing layer, which is connected via the hybrid bonding interface and is arranged to provide signal and power connections to the first transistor and the second transistor.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figure 1 is a schematic representation of a layout of a complementary field-effect transistor according to an example;
Figure 2a is a cross-sectional view of a complementary field-effect transistor according to an example,
Figure 2b is a cross-sectional view of a complementary field-effect transistor according to another example; and
Figure 3 is a flow chart of a method of manufacturing a complementary field-effect transistor according to an example.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

The present disclosure is described with reference to flow charts and/or block diagrams of the method, devices and systems according to examples of the present disclosure. Although the flow diagrams described above show a specific order of execution, the order of execution may differ from that which is depicted. Blocks described in relation to one flow chart may be combined with those of another flow chart. In some examples, some blocks of the flow diagrams may not be necessary and/or additional blocks may be added. It shall be understood that each flow and/or block in the flow charts and/or block diagrams, as well as combinations of the flows and/or diagrams in the flow charts and/or block diagrams can be realized by machine readable instructions.

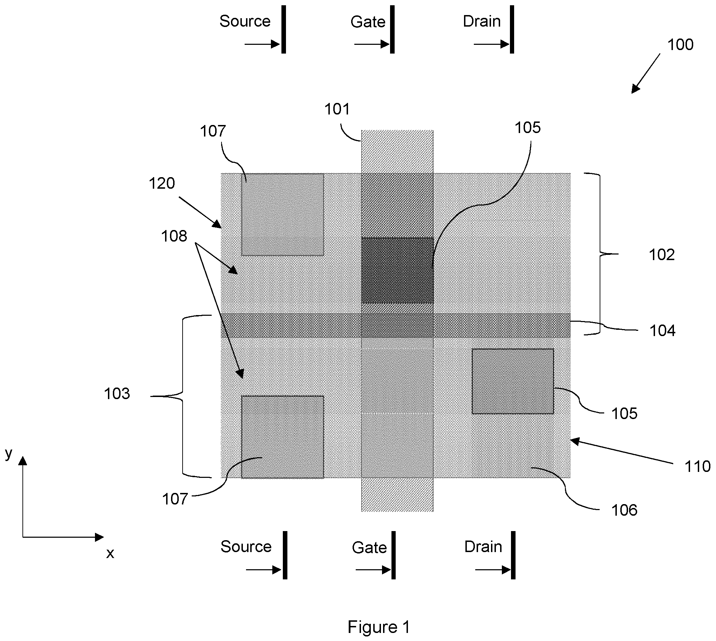

Figure 1 is a schematic representation of a layout of a complementary field-effect transistor according to an example. The complementary field-effect transistor (CFET) 100 comprises a first transistor 110 formed in a first level and a second transistor 120 formed in a second level, wherein the second level is stacked on the first level. Here, the term "level" refers to a layered arrangement in the vertical dimension, wherein the first and second transistors are positioned one on top of the other to form a stacked configuration. That is, the term "level" is used to describe the stacking of transistors. The second level is positioned directly above the first level, forming the vertical stack.

The second level may be stacked on the first level along a first axis, wherein a channel of the first transistor 110 and a channel of the second transistor 120 may be arranged along a second axis. The second axis may be perpendicular to the first axis. A portion of the channel of the first transistor 110 may overlap the channel of the second transistor 120 along a third axis. The third axis may also be perpendicular to both the first and second axes. For example, the first axis may correspond to the z-axis, representing the vertical stacking direction, the second axis may correspond to the x-axis, and the third axis may correspond to the y-axis.

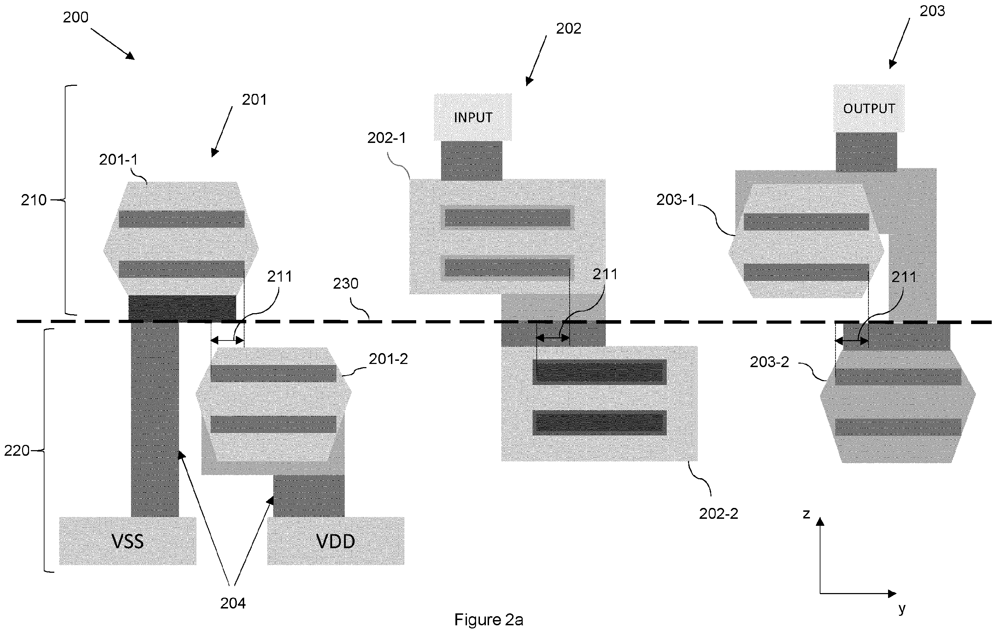

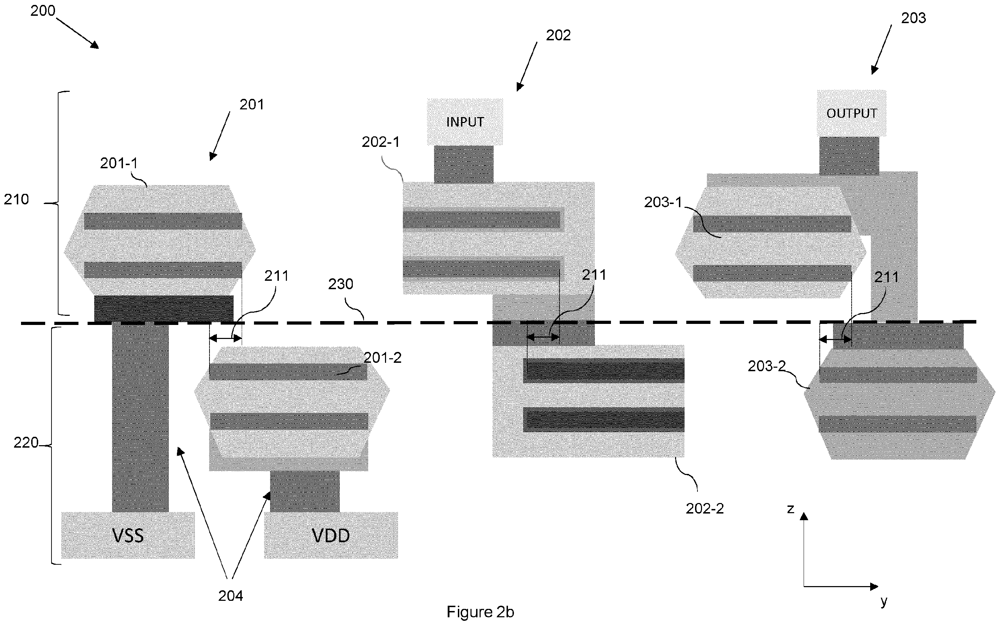

A channel of the first transistor 110 is laterally offset from a channel of the second transistor 120 while maintaining a partial overlap 104 between the channels. This offset refers to the horizontal displacement of the channels relative to each other, where portions of the channels still overlap. Such an offset may be designed to optimise routing and reduce parasitic capacitance while ensuring effective electrical connections between the layers. This will be described in more detail in relation to Figure 2, in which the overlap is clearly visible. The channels of the first transistor 110 are denoted in Figure 1 as top channels 102, while the channels of the second transistor 120 are denoted in the figure as bottom channels 103. The degree of lateral offset may be engineered based on device design constraints and performance requirements.

An amount of offset between the channel of the first transistor 110 and the channel of the second transistor 120 may be sufficient to accommodate a metal via to source/drain regions of the first transistor and an isolating dielectric between the via and the source/drain region of the second transistor.

The channel of the first transistor 110 and/or the channel of the second transistor 120 may comprise at least one nanosheet. Additionally, the channel may be surrounded by a gate electrode on three or four sides, forming either a fork-sheet transistor or a gate-all-around (GAA) transistor, respectively.

A trench contact 106 may optionally be incorporated into the device, comprising a vertical via that connects to the drain terminal of the bottom transistor 110. The trench contact 106 may serve to provide a direct electrical connection between the drain terminal of the bottom transistor 110 and external components. The trench contact 106 may be implemented as a vertical conductive structure, passing through the intervening layers to establish connectivity. An advantage of using a trench contact is that it may simplify signal and power routing within the vertically stacked CFET device 100, reducing reliance on lateral interconnects, thereby improving density and reducing resistive losses.

In addition to the trench contact, vias 105 may connect the gate electrode 101 and the source/drain terminals of the device to a horizontal metal layer 108 positioned above the CFET, facilitating signal routing. Signal routing refers to the paths created for electrical signals, providing interconnections between transistors and other components within the integrated circuit. The horizontal metal layer 108 (also referred to as M0) may comprise a thin conductive layer.

Additional vias 107 may establish connections between the transistor 100 and backside power rails. Backside power rails may be positioned on the underside of the device stack, enabling power delivery to the CFET device 100 through an optimised vertical routing scheme. The use of backside power rails may improve power integrity and reduce IR drop issues by providing a more direct and efficient power delivery network.

Source, gate, and drain terminals are explicitly shown in Figure 1. The transistor 100 may comprise a gate electrode 101, which may extend through both the first transistor 110 and the second transistor 120. The use of a shared gate electrode 101 may enable simultaneous control of both transistors, simplifying circuit design and reducing gate delay. Such a configuration may also contribute to improved switching performance and device scaling advantages.

Figure 2a provides a cross-sectional view of a complementary field-effect transistor (CFET) according to an example. Figure 2b provides a cross-sectional view of a CFET according to another example. Same reference numerals in Figures 2a and 2b denote the same elements, functioning likewise. Notably, compared to Figure 2a depicting a CFET comprising a gate terminal implemented as a gate-all-around (GAA) structure, Figure 2b illustrates a cross-sectional view of a CFET comprising a gate terminal implemented as a fork-sheet (FSH) structure.

Both Figures 2a and 2b illustrate a CFET device 200, which consists of two transistors: a first transistor with a P-channel (PMOS) fabricated on wafer 220 and a second transistor with an N-channel (NMOS) fabricated on wafer 210. In this configuration, the second transistor is vertically stacked on top of the first transistor, forming a multi-level structure. The two distinct levels-PMOS 220 (lower level) and NMOS 210 (upper level)-are separated by a hybrid bonding interface 230, which facilitates electrical connectivity between the layers and thus between the transistors, as well as providing connections to the power/signal lines. In other words, the hybrid bonding interface may be arranged between the lower level 220 and the upper level 210.

The CFET 200 various middle-of-line (MOL) interconnect structures, including vias and a trench contact (vertical metallised drain local interconnect), connected via the hybrid bonding interface 230. The MOL interconnect structures may serve to provide an intermediate level of interconnects between the device layers, bridging the connections between the front-end-of-line (FEOL), where the transistors are formed, and the back-end-of-line (BEOL), where global interconnections and power distribution networks are implemented. The MOL interconnects may comprise metal interconnects and vias.

The CFET device 200 comprises a source terminal 201, a gate terminal 202, and a drain terminal 203, all of which are depicted in the figure. As the device 200 comprises two vertically integrated transistors, each transistor has its own dedicated source region (201-1 for NMOS and 201-2 for PMOS) and drain region (203-1 for NMOS and 203-2 for PMOS), respectively. Similarly, the gate structure is divided into an NMOS gate 202-1 and a PMOS gate 202-2, each responsible for controlling its corresponding transistor.

The gate terminal 202-1, 202-2 may be implemented using a gate-all-around (GAA) structure, which refers to a transistor architecture where the gate material fully surrounds the channel on all sides. Advantageously, the use of the GAA structure may result in an improvement in electrostatic control and a reduction of short-channel effects. In Figure 2b, the gate terminal 202-1, 202-2 may instead comprise a fork-sheet (FSH) structure, which is designed to increase transistor channels width and provide more room for MOL routing between the levels. As shown in Figure 2b, compared to Figure 2a, all cuts have been modified, with the most notable change being the gate cut, which now clearly depicts a fork-like gate structure. This structure wraps the channels from three sides instead of four. As a side benefit of the increased channel width within the FSH architecture, there is now more budget for overlap, dielectric, and via placement, as may be seen from the source cut.

Power connections within the CFET device 200 may be implemented using any suitable backside power delivery method, such as vias 204 extending through the wafer and landing directly onto source terminals to provide power to the transistors.

As discussed earlier in relation to Figure 1, the first transistor's channel is laterally offset from the second transistor's channel, while still maintaining partial vertical overlap. This feature is clearly depicted in Figures 2a and 2b, where, for the source terminal 201, a partial overlap region 211 is observed between the NMOS and PMOS channels. As a result of this channel overlap, partial overlap is also present in the source terminal 201, where the NMOS source 201-1 and the PMOS source 201-2 exhibit overlap. However, the invention is not limited thereto, and the skilled person would appreciate that partial overlap is also inherently present between the NMOS drain 203-1 and the PMOS drain 203-2, as well as between the NMOS gate 202-1 and the PMOS gate 202-2. The extent of this overlap 211 may be determined by the epitaxial growth-to-via distance, which influences overall device performance and parasitic resistance.

Additionally, since the overlap occurs between the NMOS and PMOS channels, it consequently results in overlap at the source, gate, and drain terminals. The degree of channel overlap remains consistent across different terminals within the CFET device 200, as it is fundamentally determined by the lateral alignment of the channels.

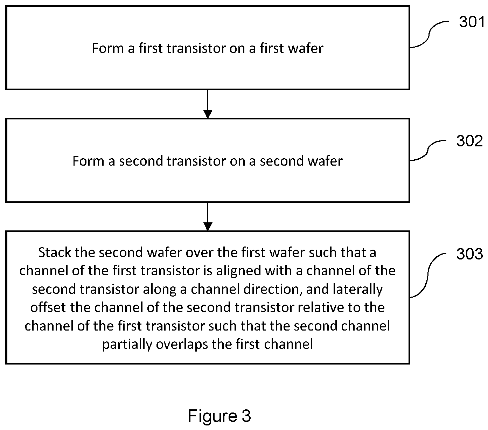

Figure 3 is a flow chart of a method of manufacturing a complementary field-effect transistor according to an example. The resulting CFET may comprise the device described above in relation to Figures 1, 2a and 2b.

The method comprises, in block 301, forming a first transistor on a first wafer. The first wafer may be equated to a first level. The first transistor may be fabricated as part of a front-end-of-line (FEOL) process, which includes forming the active regions, gate structures, and anticipated direct backside contacts for subsequent interconnections. Signal interconnects, or alternatively power and clock interconnects, may be processed at this stage, depending on the overall integration scheme. To facilitate further processing, a dummy wafer may be bonded to the first wafer, enabling the structure to be flipped, ground, and planarised using chemical mechanical polishing (CMP). Following this, backside contacts to the source and gate terminals of the first transistor may be formed.

In block 302, the method comprises forming a second transistor on a second wafer. The second wafer may be equated to a second level. As discussed above in relation to Figures 1 and 2, the second wafer may be vertically stacked on the first wafer. Similar to the first transistor, the second transistor may be fabricated using an FEOL process, where active regions, gate structures, and direct backside contacts are prepared. At this stage, power and clock interconnects, or alternatively signal interconnects, may be processed, depending on the chosen integration strategy and design requirements. A dummy wafer may then be bonded to the second wafer, enabling it to be flipped, ground, and planarised via CMP. Backside contacts to the source and gate terminals of the second transistor may subsequently be formed.

The method comprises, in block 303, stacking the second wafer over the first wafer such that a channel of the first transistor is aligned with a channel of the second transistor along a channel direction, and laterally offsetting the channel of the second transistor relative to the channel of the first transistor such that the second channel partially overlaps the first channel. The amount of lateral offset may be controlled based on design parameters, such as the required via-to-source/drain distance and overall device performance optimisation. The offset configuration may help to accommodate vertical vias and isolating dielectrics, improving overall device integration and electrical performance.

A hybrid bonding interface may be formed between the first wafer and the second wafer to electrically connect terminals of the first transistor and the second transistor. Following the bonding of both wafers, the second dummy wafer may be removed to expose power and input/output (I/O) connections, completing the fabrication process.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. A complementary field-effect transistor, CFET, device (100), comprising:
a first transistor (110) formed on a first level;
a second transistor (120) formed on a second level, wherein the second level is stacked on the first level,
wherein a channel of the first transistor (110) is offset from a channel of the second transistor (120) while maintaining partial overlap between the channels.

2. The CFET device (100) of claim 1, wherein the second level is stacked on the first level along a first axis, wherein the channel of the first transistor (110) and the channel of the second transistor (120) are arranged along a second axis, wherein the second axis is perpendicular to the first axis, wherein a portion of the channel of the first transistor (110) overlaps the channel of the second transistor (120) along a third axis, wherein the third axis is perpendicular to the first axis and the second axis.

3. The CFET device (100) of claim 1 or 2, wherein an amount of offset between the channel of the first transistor (110) and the channel of the second transistor (120) is sufficient to accommodate a metal via to source/drain regions of the first transistor (110) and an isolating dielectric between the via and source/drain region of the second transistor (120).

4. The CFET device (100) of claim 1, 2 or 3, wherein the first transistor (110) comprises an n-type metal-oxide-semiconductor, NMOS, transistor and the second transistor (120) comprises a p-type metal-oxide-semiconductor, PMOS, transistor, or the first transistor (110) comprises the PMOS transistor and the second transistor (120) comprises the NMOS transistor.

5. The CFET device (100) of any one of claims 1 to 4, wherein the channel of the first transistor (110) and/or the channel of the second transistor (120) comprises at least one nanosheet.

6. The CFET device (100) of any one of claims 1 to 5, wherein the channel of the first transistor (110) and/or the channel of the second transistor (120) comprises a channel surrounded by a gate electrode on three or four sides forming a fork-sheet or gate-all-around, GAA, transistor, respectively.

7. The CFET device of any one of claims 1 to 6, further comprising a hybrid bonding interface (230) arranged between the first transistor (110) and the second transistor (120), wherein the hybrid bonding interface (230) is arranged to electrically connect terminals of the first transistor (110) to terminals of the second transistor (120).

8. The CFET device of claim 7, further comprising a middle-of-line, MOL, routing layer, connected via the hybrid bonding interface (230) and arranged to provide signal and power connections to the first transistor (110) and the second transistor (120).

9. A semiconductor device, comprising:
a plurality of complementary field-effect transistor, CFET, devices (100), each CFET device (100) comprising:
a first transistor (110) formed in a first level; and
a second transistor (120) formed in a second level, wherein the second level is stacked on the first level,
wherein a channel of the first transistor (110) is offset from a channel of the second transistor (120) while maintaining partial overlap between the channels.

10. A method of manufacturing a complementary field-effect transistor, CFET, device, the method comprising:
forming a first transistor on a first wafer (301),
forming a second transistor on a second wafer (302);
stacking the second wafer over the first wafer such that a channel of the first transistor is aligned with a channel of the second transistor along a channel direction, and
laterally offsetting the channel of the second transistor relative to the channel of the first transistor such that the second channel partially overlaps the first channel (303).

11. The method of claim 10, wherein the second level is stacked on the first level along a first axis, wherein the channel of the first transistor and the channel of the second transistor are arranged along a second axis, wherein the second axis is perpendicular to the first axis, wherein a portion of the channel of the first transistor overlaps the channel of the second transistor along a third axis, wherein the third axis is perpendicular to the first axis and the second axis.

12. The method of claim 10 or 11, wherein an amount of offset between the channel of the first transistor and the channel of the second transistor is sufficient to accommodate a metal via to source/drain regions of the first transistor and an isolating dielectric between the via and source/drain region of the second transistor.

13. The method of claim 10, 11 or 12, wherein forming the first transistor (301) comprises forming an n-type metal-oxide-semiconductor, NMOS, transistor and forming the second transistor (302) comprises forming a p-type metal-oxide-semiconductor, PMOS, transistor, or wherein forming the first transistor (301) comprises forming the PMOS transistor and forming the second transistor (302) comprises forming the NMOS transistor.

14. The method of any one of claims 10 to 13, further comprising creating a hybrid bonding interface between the first wafer and the second wafer to electrically connect terminals of the first transistor and the second transistor.

15. The method of claim 14, further comprising forming a middle-of-line, MOL, routing layer, connected via the hybrid bonding interface and arranged to provide signal and power connections to the first transistor and the second transistor.

## Amended claims

### Amended claims in accordance with Rule 137(2) EPC.

1. A complementary field-effect transistor, CFET, device (100), comprising:
a first transistor (110) formed on a first level;
a second transistor (120) formed on a second level, wherein the second level is stacked on the first level,
wherein a channel of the first transistor (110) is offset from a channel of the second transistor (120) while maintaining partial overlap (104) between the channels,
wherein the second level is stacked on the first level along a first axis, wherein the channel of the first transistor (110) and the channel of the second transistor (120) are arranged along a second axis, wherein the second axis is perpendicular to the first axis, wherein a portion of the channel of the first transistor (110) overlaps (104) the channel of the second transistor (120) along a third axis, wherein the third axis is perpendicular to the first axis and the second axis,
wherein a trench contact (106) is incorporated into the device (100), comprising a vertical via that connects to the drain terminal of the first transistor (110), and vias (105) connect the gate electrode (101) and the source/drain terminals of the device to a horizontal metal layer (108) positioned above the CFET device (100).

2. The CFET device (100) of claim 1, wherein an amount of offset between the channel of the first transistor (110) and the channel of the second transistor (120) is sufficient to accommodate a metal via to source/drain regions of the first transistor (110) and an isolating dielectric between the via and source/drain region of the second transistor (120).

3. The CFET device (100) of claim 1 or 2, wherein the first transistor (110) comprises an n-type metal-oxide-semiconductor, NMOS, transistor and the second transistor (120) comprises a p-type metal-oxide-semiconductor, PMOS, transistor, or the first transistor (110) comprises the PMOS transistor and the second transistor (120) comprises the NMOS transistor.

4. The CFET device (100) of any one of claims 1 to 3, wherein the channel of the first transistor (110) and/or the channel of the second transistor (120) comprises at least one nanosheet.

5. The CFET device (100) of any one of claims 1 to 4, wherein the channel of the first transistor (110) and/or the channel of the second transistor (120) comprises a channel surrounded by a gate electrode on three or four sides forming a fork-sheet or gate-all-around, GAA, transistor, respectively.

6. The CFET device of any one of claims 1 to 5, further comprising a hybrid bonding interface (230) arranged between the first transistor (110) and the second transistor (120), wherein the hybrid bonding interface (230) is arranged to electrically connect terminals of the first transistor (110) to terminals of the second transistor (120).

7. The CFET device of claim 6, further comprising a middle-of-line, MOL, routing layer, connected via the hybrid bonding interface (230) and arranged to provide signal and power connections to the first transistor (110) and the second transistor (120).

8. A semiconductor device, comprising:
a plurality of complementary field-effect transistor, CFET, devices (100) of any one of the previous claims.

9. A method of manufacturing a complementary field-effect transistor, CFET, device of any one of the previous claims, the method comprising:
forming the first transistor (110) on a first wafer (301);
forming the second transistor (120) on a second wafer (302);
stacking the second wafer over the first wafer such that a channel of the first transistor is aligned with a channel of the second transistor along a channel direction, and
laterally offsetting the channel of the second transistor relative to the channel of the first transistor such that the second channel partially overlaps (104) the first channel (303),
wherein the second level is stacked on the first level along a first axis, wherein the channel of the first transistor and the channel of the second transistor are arranged along a second axis, wherein the second axis is perpendicular to the first axis, wherein a portion of the channel of the first transistor overlaps (104) the channel of the second transistor along a third axis, wherein the third axis is perpendicular to the first axis and the second axis.

10. The method of claim 9, wherein an amount of offset between the channel of the first transistor and the channel of the second transistor is sufficient to accommodate a metal via to source/drain regions of the first transistor and an isolating dielectric between the via and source/drain region of the second transistor.

11. The method of claim 9 or 10, wherein forming the first transistor (301) comprises forming an n-type metal-oxide-semiconductor, NMOS, transistor and forming the second transistor (302) comprises forming a p-type metal-oxide-semiconductor, PMOS, transistor, or wherein forming the first transistor (301) comprises forming the PMOS transistor and forming the second transistor (302) comprises forming the NMOS transistor.

12. The method of any one of claims 9 to 11, further comprising creating a hybrid bonding interface between the first wafer and the second wafer to electrically connect terminals of the first transistor and the second transistor.

13. The method of claim 12, further comprising forming a middle-of-line, MOL, routing layer, connected via the hybrid bonding interface and arranged to provide signal and power connections to the first transistor and the second transistor.
